# EUROPEAN PATENT APPLICATION

(11) **EP 2 840 873 A1**
(43) Date of publication of application: **25.02.2015**
(21) Application number: 12874799.5
(22) Date of filing: 19.04.2012
(51) Int. Cl.: H05K 3/34, B23P 19/04, B25J 9/16, B65G 21/20

(54) **ROBOT SYSTEM**

(71) Applicant: Kabushiki Kaisha Yaskawa Denki, Kitakyushu-shi, Fukuoka 806-0004 (JP)
(72) Inventor: SHIINO, Takashi, Kitakyushu-shi Fukuoka 806-0004 (JP); ISHIBASHI, Keigo, Kitakyushu-shi Fukuoka 806-0004 (JP); IKEDA, Toshiaki, Kitakyushu-shi Fukuoka 806-0004 (JP); HARADA, Toshiyuki, Kitakyushu-shi Fukuoka 806-0004 (JP); KOYAKUMARU, Shoji, Kitakyushu-shi Fukuoka 806-0004 (JP)
(74) Representative: Grünecker, Kinkeldey, Stockmair & Schwanhäusser
(86) International application number: PCT/JP2012/060599
(87) International publication number: WO 2013/157121

(57) **Abstract**

An object of the present embodiment is to provide a robot system that can efficiently remove a tape member stuck on a workpiece. To solve the problem, a robot system (1) according to an aspect of the present embodiment includes a robot (a first robot) (20) and a controller (60). The robot (20) has a robot hand (hand; 21) equipped with one set of gripping claws (21b) that grips a tape member stuck on a workpiece to be processed. The controller (60) instructs the robot (20) to perform operation of peeling off the tape member while gripping the end of the tape member with the gripping claws (21b).

## Description

### Field

The disclosed embodiment relates to a robot system.

### Background

Various proposals on robot systems have been made for improving the efficiency of a production line by allowing a predetermined processing work for a workpiece to be processed (hereinafter referred to as "workpiece") that has been conventionally made by a person, for example, in a production line for processed products to be performed by a robot.

An example of the robot system is one that allows a processing work of sticking a tape member such as a masking tape or a protective tape to a predetermined position of the workpiece to be performed by a robot (see, for example, Patent Literature 1). In the robot system of Patent Literature 1, the stuck tape member is finally removed by a worker's hand.

### Citation List

### Patent Literature

Patent Literature 1: Japanese Patent Application Laid-open No. 2008-285285

### Summary

### Technical Problem

In the robot system, however, there is a room for further improvement in efficiency for removal by manpower of a tape member stuck on a workpiece.

An aspect of the embodiment has been made in consideration of the above problem, and an object of an aspect of the embodiment is to provide a robot system that can efficiently remove a tape member stuck on a workpiece.

### Solution to Problem

A robot system according to an aspect of an embodiment includes a robot and a controller. The robot includes a robot hand provided with one set of gripping claws that hold a tape member stuck on a workpiece to be processed. The controller instructs the robot to perform operation of peeling off the tape member while holding an end of the tape member with the gripping claws.

### Advantageous Effects of Invention

In one aspect of the present embodiment, a tape member stuck on a workpiece can be efficiently removed.

### Brief Description of Drawings

Fig. 1A is a schematic plan view illustrating the whole construction of a robot system in an embodiment.
Fig. 1B is a schematic view of a workpiece.
Fig. 2 is a block diagram of a robot system in an embodiment.
Fig. 3A is a schematic side view illustrating a construction of a transporter.
Fig. 3B is a schematic side view illustrating a construction of a transporter.
Fig. 4A is a schematic plan view illustrating operation of a transporter.
Fig. 4B is a schematic plan view illustrating operation of a transporter.
Fig. 5 is a schematic side view illustrating a construction of a first robot.
Fig. 6A is a schematic front view illustrating a construction of a hand of a first robot.
Fig. 6B is a schematic perspective view illustrating a construction of a hand of a first robot.
Fig. 7A is an explanatory view illustrating operation of a first robot.
Fig. 7B is an explanatory view illustrating operation of a first robot.
Fig. 7C is an explanatory view illustrating operation of a first robot.
Fig. 7D is an explanatory view illustrating operation of a first robot.
Fig. 7E is an explanatory view illustrating operation of a first robot.
Fig. 7F is an explanatory view illustrating operation of a first robot.
Fig. 7G is an explanatory view illustrating operation of a first robot.
Fig. 8A is a schematic perspective view illustrating a construction of a hand of a second robot.
Fig. 8B is a schematic front view illustrating a construction of a hand of a second robot.
Fig. 8C is an explanatory view illustrating operation of a second robot.

### Description of Embodiments

Embodiments of the robot system disclosed in the present application will be described in more detail with reference to the accompanying drawings. It should be noted that the present invention is not limited to the embodiments described below.

In the following description, a workpiece to be processed is a substrate for electronic devices to which electronic components have been soldered in a previous step. Further, the following description will be made by taking as an example a robot system that performs processing which comprises peeling off a masking tape previously stuck on a substrate for masking in soldering and cutting an excessive lead wire extended from an electronic component. Further, in the following description, the substrate is sometimes described as a "workpiece".

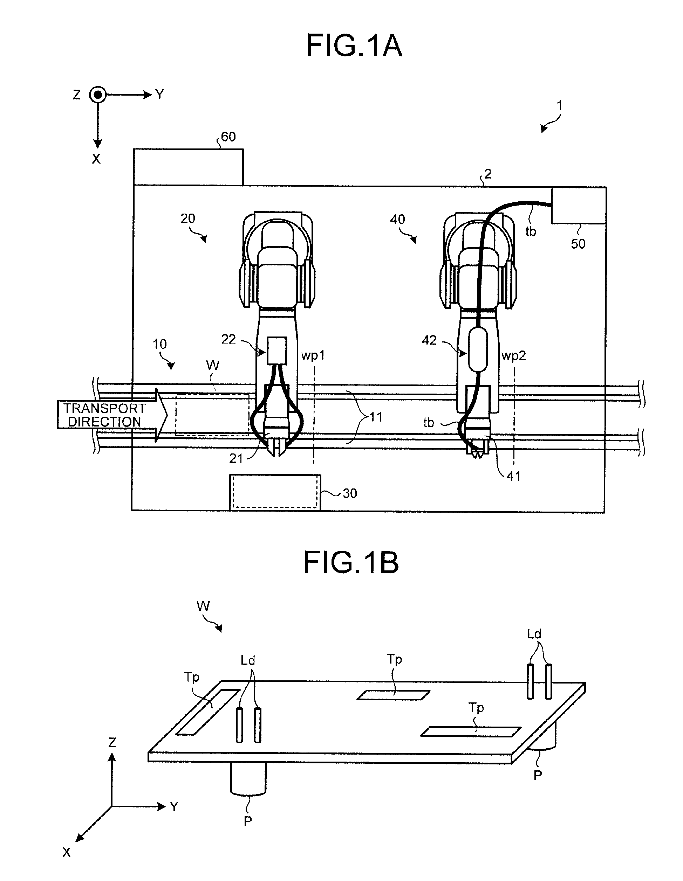

Fig. 1A is a schematic plan view illustrating the whole construction of a robot system 1 in an embodiment. A three-dimensional orthogonal coordinate system including a Z axis in which a vertical and upward direction is a positive direction for easy understanding purposes is illustrated in Fig. 1A. The orthogonal coordinate system is also sometimes illustrated in other drawings that will be described below. In this embodiment, the positive direction of an X axis refers to a fore of the robot system 1.

As illustrated in Fig. 1A, the robot system 1 includes a cell 2 that defines a rectangular parallelepiped working space. In the robot system 1, a transporter 10, a first robot 20, a tape housing 30, a second robot 40, and a lead section housing 50 are provided inside the cell 2.

Further, in the robot system 1, a controller 60 is provided outside the cell 2. The controller 60 is connected to various devices such as the transporter 10, the first robot 20, and the second robot 40 so that information can be transmitted.

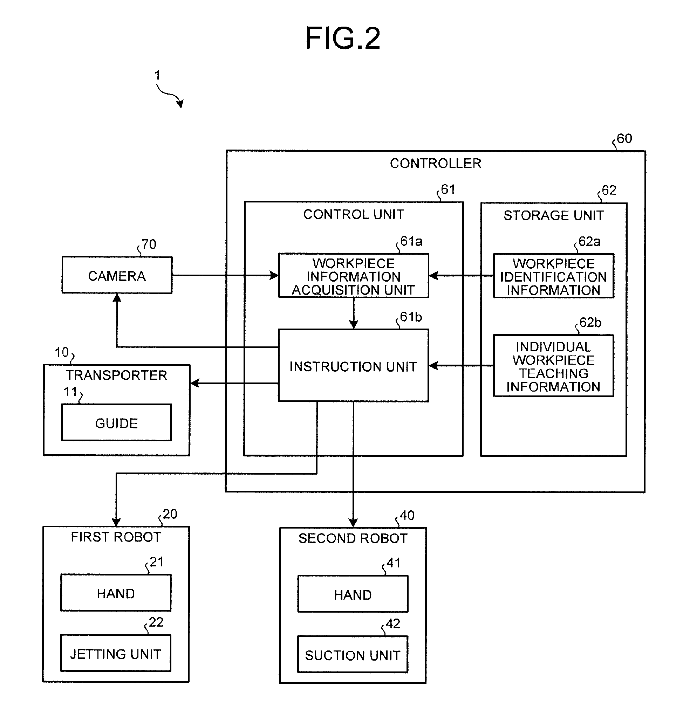

The controller 60 is a controller that regulates operation of connected various devices and is constituted by various control instruments and arithmetic processors, a storage device and the like. Details of the controller 60 will be described later with reference to Fig. 2.

In Fig. 1, the controller 60 is of a one housing type. However, the controller 60 is not limited thereto. For example, the controller 60 may be constituted by a plurality of housings associated respectively with various devices that are objects to be controlled. The controller 60 may be provided inside the cell 2.

The transporter 10 is a unit that is provided parallel to and along a transport direction in the drawing, that has a pair of guides 11 with spacing therebetween being variable, and that transports a workpiece W while restricting the movement of the workpiece W present in an area between the pair of guides 11 toward the spacing by the pair of guides 11.

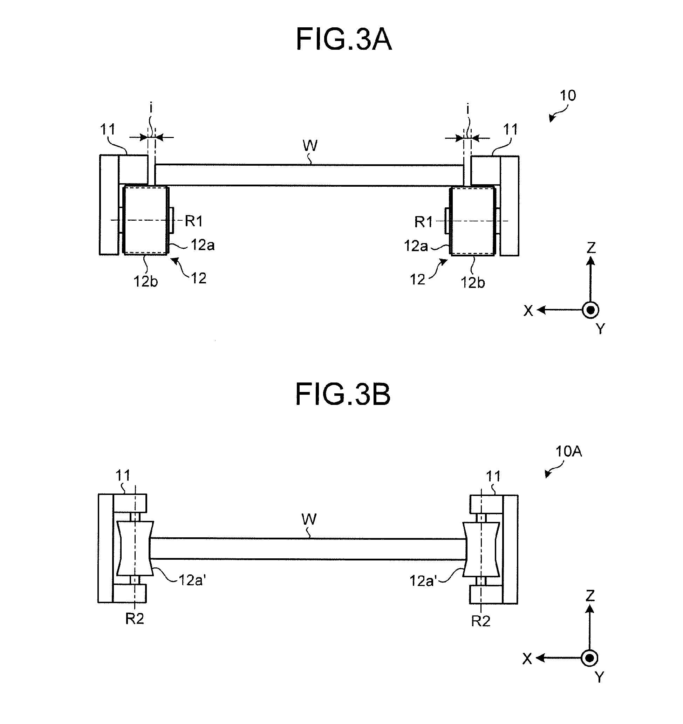

The transporter 10 sandwiches and holds the workpiece W by the pair of guides 11 at a working position wp1 of the first robot 20 and at a working position wp2 of the second robot 40. The transporter 10 will be described in more detail later with reference to Figs. 3A to 4B.

Here the workpiece W will be described. Fig. 1B is a schematic view of a workpiece W. As illustrated in Fig. 1B, the workpiece W is a substrate with an electronic component P mounted thereon. The workpiece W is transported from the previous step in such a state that the electronic component P mounted surface faces downward (a negative direction in the Z axis), and, in the robot system 1, the back surface that faces upward (a positive direction in the Z axis) is processed.

As illustrated in Fig. 1B, for example, a masking tape Tp stuck for masking purposes in soldering in the previous step and a lead wire Ld extended from the electronic component P are exposed on the back surface.

An explanation will be again made on Fig. 1A.

The first robot 20 is a single-arm manipulator that, when received an instruction of operation from the controller 60, performs operation for the removal of the masking tape Tp in the workpiece W, and a robot hand (hereinafter described as "hand") 21 is provided at a terminal movable part in an arm. The hand 21 includes one set of gripping claws (which will be described later) that grips the end of the masking tape Tp.

The first robot 20 further includes a jetting unit 22 that jets air from near a front end of the gripping claws in the hand 21. The first robot 20 peels off the masking tape Tp from the workpiece W with the gripping claws, and the peeled masking tape Tp is blown away toward the tape housing 30 by air jetted from the jetting unit 22 to remove the masking tape Tp. The tape housing 30 is a housing that is open toward the first robot 20.

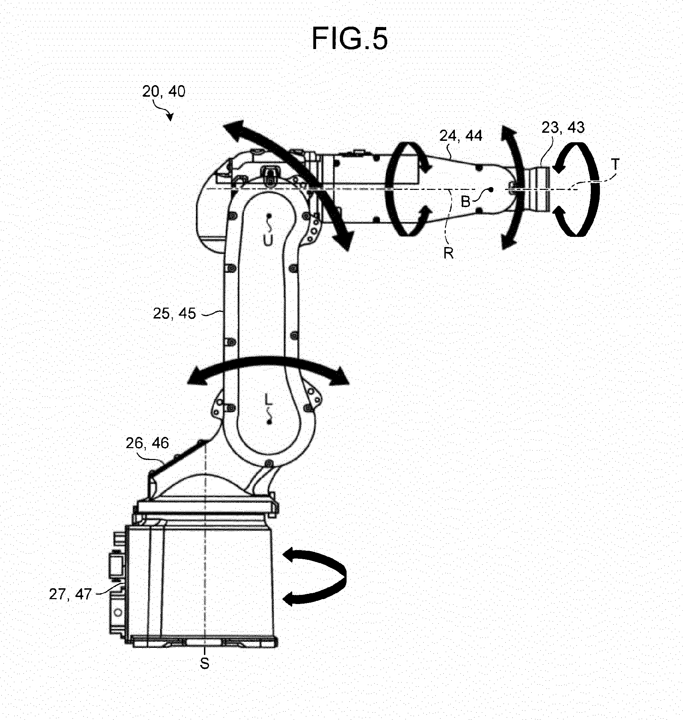

The construction and operation of the first robot 20 will be described in more detail later with reference to Figs. 5 to 7G.

The second robot 40 is a single-arm manipulator that receives an instruction of operation from the controller 60 and is operated to cut an excessive lead wire Ld of the workpiece W. The second robot 40 includes a hand 41 at a terminal movable part of an arm. The hand 41 includes a cutting tool that cuts the lead wire Ld. For example, an air nipper is suitable as the cutting tool.

The second robot 40 includes a suction unit 42 that suctions sections of the cut lead wire Ld (hereinafter described as "lead section"). The suction unit 42 includes a suction tube tb connected to a lead section housing 50, and the lead section suctioned by the suction unit 42 is housed in the lead section housing 50 through the suction tube tb.

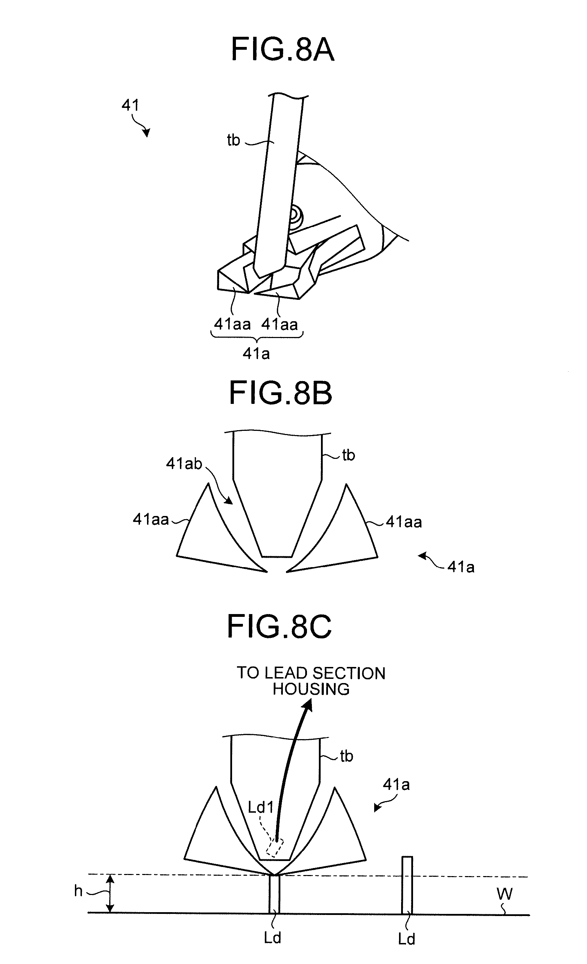

The construction and operation of the second robot 40 will be described in more detail later with reference to Fig. 5 and Figs. 8A to 8C.

The robot system 1 includes a camera which is not illustrated in Fig. 1. The camera appropriately takes an image of the workpiece W according to an instruction from the controller 60, and imaged data are handed over to the controller 60.

Next, a block configuration of a robot system 1 in an embodiment will be described with reference to Fig. 2.

Fig. 2 is a block diagram of the robot system 1 in an embodiment. In Fig. 2, only constituent elements necessary for the explanation of the robot system 1 are illustrated, and the description of general constituent elements is omitted.

For an explanation with reference to Fig. 2, an internal construction of the controller 60 will be mainly described, and the explanation of various devices already illustrated in Fig. 1 will be sometimes omitted.

As illustrated in Fig. 2, the controller 60 includes a control unit 61 and a storage unit 62. The control unit 61 further includes a workpiece information acquisition unit 61a, and an instruction unit 61b. The storage unit 62 stores workpiece identification information 62a and individual workpiece teaching information 62b.

The control unit 61 performs the whole control of the controller 60. The workpiece information acquisition unit 61a receives imaged data on the workpiece W from the camera 70 and performs matching the received imaged data and the workpiece identification information 62a to identify the type of the workpiece W that is a work to be processed.

Here the workpiece identification information 62a is information that identifies the type of the workpiece W such as the shape and dimension of the workpiece W and the position and number of holes in the workpiece W. The workpiece identification information 62a is previously registered in the storage unit 62.

The camera 70 is provided, for example, at a ceiling of the cell 2 and near the first robot 20 and the second robot 40, and, in each step in the inside of the cell 2, an image of the workpiece W is taken based on an instruction from the instruction unit 61b.

Based on imaged data of the camera 70, the workpiece information acquisition unit 61a also acquires the state of the workpiece W such as the absence or presence of abnormality that, together with the identified type of the workpiece W, is informed as workpiece information to the instruction unit 61b.

Based on the informed workpiece information and the individual workpiece teaching information 62b, the instruction unit 61b generates operation signals that operate various devices such as the transporter 10, the first robot 20, the second robot 40, and the camera 70. The signals are output to the various devices.

The individual workpiece teaching information 62b is information including teaching data for various devices of the robot system 1 and is previously registered through an input unit (for example, a programming pendant) that is not shown. The teaching data include mode of processing operation for the workpiece W (specifically, information about the position where the masking tape Tp is removed and the position where the lead wire Ld is cut).

The construction and operation of various devices that are operated based on an instruction from the instruction unit 61b will be described in more detail. The construction and operation of the transporter 10 will be described with reference to Figs. 3A to 4B.

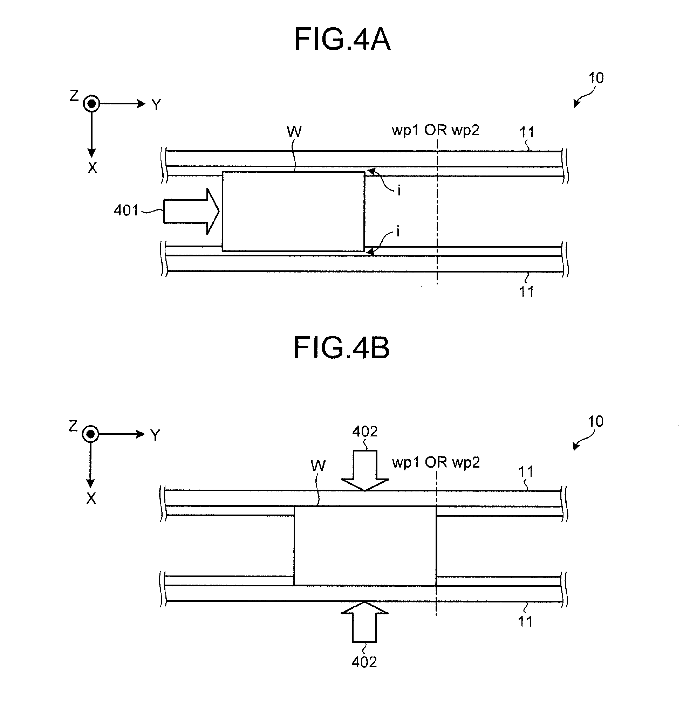

Figs. 3A and 3B are schematic side views illustrating a construction of the transporter 10. Figs. 3A and 3B are figures as viewed from a positive direction of the Y axis but may also be regarded as being viewed from a negative direction of the Y axis. Figs. 4A and 4B are schematic plan views illustrating the operation of the transporter 10.

As illustrated in Fig. 3A, the transporter 10 includes a pair of guides 11 that are arranged parallel to and along the Y axis in the drawing, the spacing between the guides 11 being variable.

Further, in each of the guides 11, a conveyor 12 is additionally provided that includes a roller 12a rotatable around a rotation axis R1 parallel to the X axis in the drawing, and a belt 12b wound on the roller 12a. The workpiece W is mounted on the conveyor 12 and is conveyed.

As shown in Fig. 3A, in the transporter 10, for the workpiece W being transported, a gap i that is greater than 0 (zero) and in a predetermined range (for example, about 0.3 mm) is provided between the workpiece W and the guides 11.

Here, Fig. 3A illustrates an example where the gap i is provided at both ends of the workpiece W. However, the workpiece W may be set to the side of any one of the guides 11.

As shown in Fig. 3B, the transporter may also be constructed as a transporter 10A that does not have the gap i and transports the workpiece W. This construction can be realized, for example, by, as shown in Fig. 3B, providing a roller 12a' rotatable around a rotation axis R2 parallel to the Z axis in the drawing along the guides 11. That is, even when there is no gap i between the conveyor 12 and the workpiece W and the workpiece W is in contact with the conveyor 12, a construction in which the conveyor 12 is slidable suffices for the present embodiment.

In this embodiment, an explanation is made on the assumption that the transporter 10 exemplified in Fig. 3A is adopted. The instruction unit 61b (see Fig. 2) instructs the transporter 10 to perform the following operation.

Specifically, as illustrated in Fig. 4A, the instruction unit 61b instructs the transporter 10 to transport the workpiece W along a transport direction indicated by an arrow 401 while restricting the workpiece W in an area between the pair of guides 11 with the gap i being provided between the workpiece W and the pair of guides 11 until the workpiece W reaches the working position wp1 or the working position wp2.

As illustrated in Fig. 4B, when the workpiece W reaches the working position wp1 or the working position wp2, the instruction unit 61b instructs the transporter 10 to sandwich and hold the workpiece W from a direction substantially orthogonal to the transport direction (that is, X axis direction) by the pair of guides 11 (see an arrow 402 in the drawing). Only one of the guides 11 may be driven to press the workpiece W against the other guide 11.

The operation to sandwich the workpiece W in this way can be realized by connecting the pair of guides 11 by a spline shaft and the like.

According to this method, at the working position wp1 or the working position wp2, the workpiece W can be reliably fixed. Thus, misregistration of the workpiece W in processing can be prevented, and the accuracy of processing conducted by the first robot 20 or the second robot 40 can be improved.

The construction and operation of the first robot 20 will be described with reference to Figs. 5 to 7G. Fig. 5 is a schematic side view illustrating a construction of the first robot 20.

Fig. 5 is also a schematic side view illustrating a construction of the second robot 40. Specifically, in this embodiment, the first robot 20 and the second robot 40 are of the same type. In Fig. 5, reference characters within parentheses represent individual constituent elements in the second robot 40 corresponding to those in the first robot 20. This does not prevent the first robot 20 and the second robot 40 from being different from each other.

As illustrated in Fig. 5, the first robot 20 is a single-arm multiaxial robot. Specifically, the first robot 20 includes a first arm 23, a second arm 24, a third arm 25, a fourth arm 26, and a base 27.

The proximal end of the first arm 23 is supported by the second arm 24. The proximal end of the second arm 24 is supported by the third arm 25, and the front end of the second arm 24 supports the first arm 23.

The proximal end of the third arm 25 is supported by the fourth arm 26, and the front end of the third arm 25 supports the second arm 24. The proximal end of the fourth arm 26 is supported by the base 27 fixed, for example, to a floor of a working space, and the front end of the fourth arm 26 supports the third arm 25.

An actuator is mounted on each of joints (not shown) that are connections of the first arm 23 to the base 27, and the first robot 20 performs multiaxial operation through drive of the actuators controlled by the instruction unit 61b.

Specifically, the actuator at the joint that connects the first arm 23 and the second arm 24 rotates the first arm 23 around B axis. The actuator at the joint that connects the second arm 24 and the third arm 25 rotates the second arm 24 around U axis.

The actuator at the joint that connects the third arm 25 and the fourth arm 26 rotates the third arm 25 around L axis.

Further, the actuator at the joint that connects the fourth arm 26 and the base 27 rotates the fourth arm 26 around S axis.

The first robot 20 includes individual actuators that respectively rotate the first arm 23 around T axis and the second arm 24 around R axis. That is, the first robot 20 has six axes.

The front end of the first arm 23 is the terminal movable part of the first robot 20, and the hand 21 is mounted on the terminal movable part. The hand 21 will be then described.

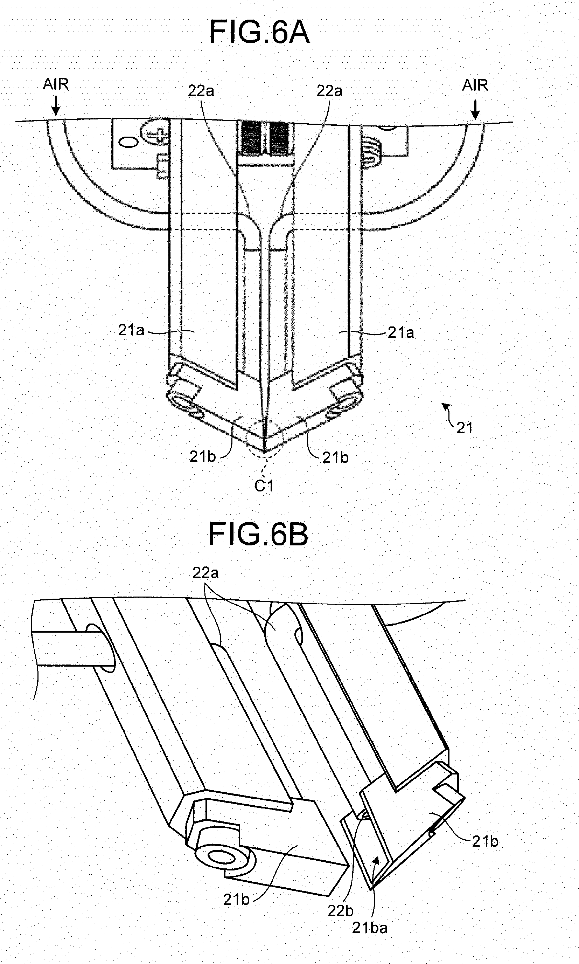

Fig. 6A is a schematic front view illustrating a construction of the hand 21 in the first robot 20. Fig. 6B is a schematic perspective view illustrating a construction of the hand 21 in the first robot 20.

As illustrated in Fig. 6A, the hand 21 includes a pair of opening/closing units 21a. The gripping claw 21b that is a gripping member which grips the masking tape Tp is provided at each front end of the opening/closing units 21a.

In Fig. 6A, the pair of opening/closing units 21a is in a closed state. When the pair of opening/closing units 21a are in a closed state, the gripping claws 21b have an obliquely cut sharply-angled front end so that the front ends come into linear contact with each other (see a portion surrounded by a closed curve C1 in the drawing).

According to this constitution, an area of contact with an adhesive face of the masking tape Tp in gripping the masking tape Tp can be reduced, and, thus, the masking tape Tp can easily be blown away by jetting air, that is, can easily be removed.

Further, the area of contact with the workpiece W in peeling off the masking tape Tp can be reduced, and, thus, damage to the workpiece W is less likely to occur.

Further, the gripping claws 21b is suitably formed of a flexible material such as resin. This also renders the workpiece W less likely to be damaged.

As illustrated in Fig. 6A, a nozzle 22a that is a passage of air from a jetting unit 22 is provided in each of the opening/closing units 21a. As illustrated in Fig. 6A, the nozzle 22a is extended from an outer side of the opening/closing unit 21a through and toward an inner side of the opening/closing unit 21a.

As illustrated in Fig. 6B, a recess 21ba is formed in surfaces of the gripping claws 21b that face each other, and a jetting nozzle 22b located at the end of the nozzle 22a is provided in each of the recesses 21ba.

Thus, the provision of the nozzle 22a and the jetting nozzle 22b can prevent jetting mechanisms including the jetting unit 22 from posing a problem of gripping operation of the hand 21 as a result of interference with the opening/closing units 21a and the gripping claws 21b.

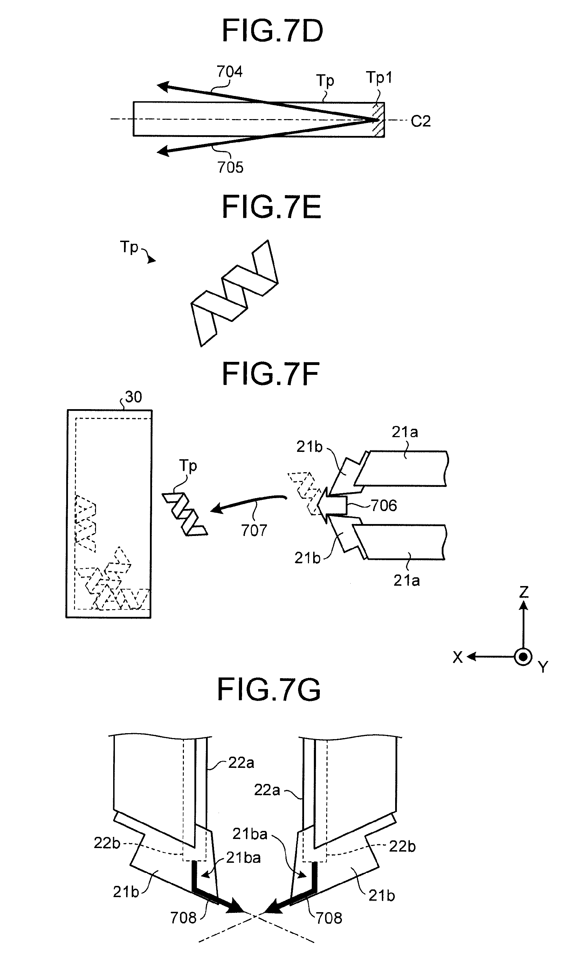

The provision of the jetting nozzle 22b in each of the gripping claws 21b is advantageous in that, even when the peeled masking tape Tp is adhered on only any one of the gripping claws 21b, air can be reliably blown against the masking tape Tp to remove the masking tape Tp. This will be described in conjunction with an explanation with reference to Fig. 7G that will be described later.

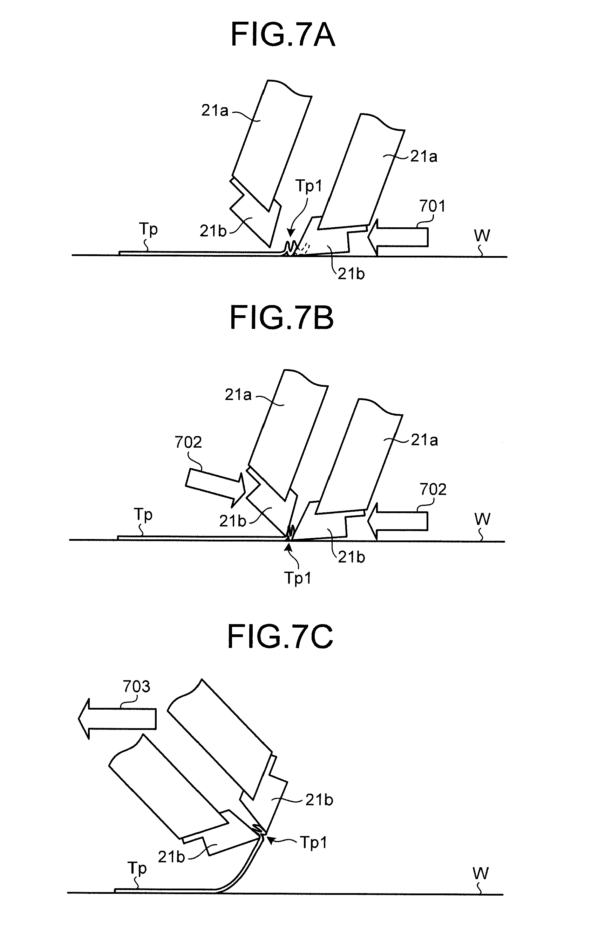

Next, the operation of the first robot 20 instructed by the instruction unit 61b after the fixation of the workpiece W to the working position wp1 will be described. Figs. 7A to 7G are explanatory views illustrating the operation of the first robot 20.

As shown in Fig. 7A, the instruction unit 61b instructs the first robot 20 to perform operation that includes opening the pair of opening/closing units 21a and scarifying the end of the masking tape Tp while abutting one of the gripping claws 21b against the workpiece W (see an arrow 701 in the drawing). In the scarifying operation, the gripping claws 21b may be swung. A reference character Tp1 represents an end of the masking tape Tp scarified by the operation.

As illustrated in Fig. 7B, the instruction unit 61b instructs the first robot 20 to perform operation that includes closing the pair of opening/closing units 21a and gripping the scarified end Tp1 with the pair of gripping claws 21b (see an arrow 702 in the drawing).

As shown in Fig. 7C, the instruction unit 61b instructs the first robot 20 to perform operation that includes peeling off the masking tape Tp while gripping the end Tp1 with the pair of gripping claws 21b (see an arrow 703 in the drawing).

For the operation of peeling off the masking tape Tp, the first robot 20 is instructed so that, as illustrated in Fig. 7D, the masking tape Tp is peeled off from the end Tp1 (see a hatched area in the drawing) obliquely to a center line C2 in the masking tape Tp (see an arrow 704 or an arrow 705 in the drawing).

Accordingly, as illustrated in Fig. 7E, the peeled masking tape Tp can be made spiral. The spiral masking tape Tp advantageously increases the surface area of the masking tape Tp that receives air, making it easy to blow away the masking tape Tp. Further, the operation of peeling of the masking tape Tp in an oblique direction can allow the front end of the gripping claws 21b to be directed toward the opening of the tape housing 30 in a short distance. That is, this contributes to an improvement in throughput.

Further, as shown in Fig. 7F, the instruction unit 61b instructs the first robot 20 to perform operation that includes directing the front end of the gripping claws 21b toward the opening of the tape housing 30, opening the pair of opening/closing units 21a, and jetting air from the front end of the gripping claws 21b (see an arrow 706 in the drawing).

This allows the masking tape Tp to which air has been jetted to be blown away toward the tape housing 30 and to be housed in the tape housing 30 (see an arrow 707 in the drawing). The instruction unit 61b then instructs the first robot 20 to repeat a series of operations illustrated in Figs. 7A to 7F until the masking tape Tp to be removed is entirely removed from the workpiece W.

As described above in conjunction with Fig. 6A, the front end of the gripping claws 21b has an obliquely cut sharply-angled shape (see Fig. 7G). Further, as described above in conjunction with Fig. 6B, the jetting nozzle 22b located at the end of the nozzle 22a is provided in the recess 21ba formed in each of the surfaces of the gripping claws 21b that face each other (See Fig. 7G).

These can realize the function and effect illustrated in Fig. 7G. That is, as illustrated in Fig. 7G, the air jetted from the jetting nozzle 22b collides against the inner wall of the recess 21ba, and the jetting direction is changed along the shape of the obliquely cut gripping claws 21b.

That is, as indicated by an arrow 708 in the drawing, the jetting directions of the air cross each other at the outer side of the front end of the gripping claws 21b. This allows airs to collide against each other at the outer side of the front end of the gripping claws 21b to create turbulent flow. Accordingly, even when the masking tape Tp is adhered on only any one of the gripping claws 21b, the masking tape Tp can be caught in the turbulent flow and reliably blown away.

Further, tape members such as the masking tape Tp can be efficiently removed without labor by constituting the first robot 20 as described above and operating the first robot 20.

Next, the construction and operation of the second robot 40 will be described in conjunction with Figs. 8A to 8C. Since construction of the second robot 40 is the same as that of the first robot 20 described in conjunction with Fig. 5, the explanation thereof is omitted and an explanation will be made on a hand 41 mounted on the terminal movable part (first arm 43: see Fig. 5) of the second robot 40.

Fig. 8A is a schematic perspective view illustrating a construction of a hand 41 in a second robot 40, and Fig. 8B is a schematic front view illustrating the construction of the hand 41 in the second robot 40. Fig. 8C is an explanatory view illustrating the operation of the second robot 40.

As illustrated in Fig. 8A, the hand 41 includes a nipper 41a having a pair of blades 41aa. The nipper 41a is a cutting tool that cuts an excess lead wire Ld of the workpiece W. When the fact that a manipulator is used rather than labor is taken into consideration, an air nipper is suitable as the nipper 41a.

The hand 41 further includes a suction tube tb that is connected to a lead section housing 50 (see Fig. 1) through a suction unit 42 (see Fig. 1) that suctions a lead section.

Here, as illustrated in Fig. 8B, the front end of the suction tube tb is in a pursed form. As illustrated in Fig. 8B, this allows the front end of the suction tube tb to be provided at a deeper position of the recess 41ab formed on the pair of blades 41aa, and, thus, a lead section produced by cutting with the nipper 41a can be reliably suctioned just after the production of the lead section.

Subsequently, the operation of the second robot 40 instructed by the instruction unit 61b after the fixation of the workpiece W to the working position wp2 will be described.

As illustrated in Fig. 8C, the instruction unit 61b instructs the second robot 40 to cut a portion beyond a predetermined height h in a lead wire Ld exposed beyond the height h (for example, about 3 mm) from the workpiece W with the nipper 41a and to drive the suction unit 42.

That is, simultaneously with cutting with the nipper 41a, a force of suction into the lead section housing 50 is applied to the lead section Ld1. This allows the lead section Ld1 to be reliably suctioned just after the production of the lead section Ld1.

The instruction unit 61b then instructs the second robot 40 to repeat the operation illustrated on Fig. 8C until the lead wire Ld to be cut is entirely cut from the workpiece W.

When the processing work of the workpiece W by the second robot 40 has been completed, the instruction unit 61b instructs the transporter 10 to transport the workpiece W to a post-process in the exterior of the cell 2.

With reference to Fig. 2 again, the storage unit 62 in the controller 60 will be described. The storage unit 62 is a storage device such as a hard disk drive or a non-volatile memory and stores workpiece identification information 62a and individual workpiece teaching information 62b. The workpiece identification information 62a and the individual workpiece teaching information 62b have already been described above, and, thus, explanation thereof will be omitted.

Individual constituent elements illustrated in Fig. 2 may not be disposed in the controller 60 alone. For example, any one of or all the workpiece identification information 62a and the individual workpiece teaching information 62b stored in the storage unit 62 may be stored in an internal memory in the first robot 20 and the second robot 40 to improve the throughput.

In the description in conjunction with Fig. 2, an example has been given where the controller 60 acquires workpiece information based, for example, on previously registered workpiece identification information 62a, individual workpiece teaching information 62b, and imaged data from the camera 70. Alternatively, necessary workpiece information may be successively acquired from a higher-level device that is connected to the controller 60 so that intercommunication is possible.

As described above, the robot system in the embodiment includes a robot and a control unit. The robot includes a robot hand comprising one set of gripping claws that grips a tape member stuck on a workpiece that is a piece of work to be processed. The control unit instructs the robot to perform operation of peeling off the tape member while gripping the end of the tape member with the gripping claws.

Thus, according to the robot system in the embodiment, the tape member stuck on the workpiece can be efficiently removed.

In the embodiment, an example has been given where the workpiece that is a piece of work to be processed is a substrate for electronic devices with an electronic component soldered thereto in the previous step. The present embodiment, however, is not limited thereto, and any type and shape of the workpiece may be adopted as long as transportation and sandwiching by the transporter are possible.

In the embodiment, a single-arm robot has been described as an example. The present embodiment, however, is not limited thereto, and multi-arm robots comprising two or more arms may also be used. For example, when a double-arm robot is used, a construction may be adopted in which the masking tape is removed with a hand provided in one of the arms while a lead wire is cut with the other hand.

In the embodiment, a multiaxial robot having six axes per arm has been described as an example. However, the number of axes is not limited thereto.

In the embodiment, a hand having a pair of gripping claws has been described as an example. The gripping claws, however, are not limited thereto, and two or more gripping claws may constitute one set of gripping claws.

In the embodiment, a masking tape has been described as an example of the tape member. The type of the tape is not of course limited thereto.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

### Reference Signs List

1 robot system
2 cell
10 transporter
10A transporter
11 guide
12 conveyor
12a roller
12b belt
20 first robot
21 hand
21a opening/closing unit
21b gripping claws
21ba recess
22 jetting unit
22a nozzle
22b jetting nozzle
23 first arm
24 second arm
25 third arm
26 fourth arm
27 base
30 tape housing
40 second robot
41 hand
41a nipper
41aa blade
41ab recess
42 suction unit
50 lead section housing
60 controller
61 control unit
61a workpiece information acquisition unit
61b instruction unit
62 storage unit
62a workpiece identification information
62b individual workpiece teaching information
70 camera
Ld lead wire
Ld1 lead section
P electronic component
Tp masking tape
Tp1 end
W workpiece
tb suction tube
wp1 working position
wp2 working position

## Claims

1. A robot system comprising:
a robot including a robot hand provided with one set of gripping claws that hold a tape member stuck on a workpiece to be processed; and
a controller that instructs the robot to perform operation of peeling off the tape member while holding an end of the tape member with the gripping claws.

2. The robot system according to claim 1, wherein
the controller instructs the robot to perform operation of peeling off the tape member in an oblique direction to a center line of the tape member.

3. The robot system according to claim 1 or 2, wherein
the robot further comprises a jetting mechanism that jets air from a jetting nozzle provided at a position near a front end of the gripping claws, and
the controller instructs the robot to perform operation through which the front end of the gripping claws is directed toward a predetermined direction while holding the peeled tape member, and air is jetted through the jetting nozzle, thereby blowing away the tape member.

4. The robot system according to claim 1, 2, or 3, wherein
the controller instructs the robot to perform operation through which the end is scarified while abutting the gripping claws against the workpiece, and the scarified end is held.

5. The robot system according to claim 3 or 4, wherein
recesses are formed on the gripping claws on their surfaces that face to each other, and
the jetting nozzle is provided in each of recesses and is disposed in a direction that the direction of the air jetted crosses on an outer side of the front end of the gripping claws.

6. The robot system according to any one of claims 3 to 5, further comprising
a housing that is provided in a substantially stretching direction in the predetermined direction and houses the tape member that has been blown away.

7. The robot system according to any one of claims 1 to 6, further comprising
a transporter that has a pair of guides arranged parallel to each other along a predetermined transport direction, the guides having a variable spacing therebetween, that transports the workpiece to a working position of the robot while restricting the movement of the workpiece present in an area between the pair of guides toward the direction of the spacing, and that sandwiches and holds the workpiece by the pair of guides at the working position.
